# EUROPEAN PATENT APPLICATION

(11) **EP 1 571 534 A2**
(43) Date of publication of application: **07.09.2005**
(21) Application number: 04005453.8
(22) Date of filing: 08.03.2004
(51) Int. Cl.: G06F 1/20

(54) **Electronic apparatus having cooling system, radiator thereof, and method for manufacturing thereof**

(30) Priority: 16.02.2004 JP 2004038148
(71) Applicant: Hitachi, Ltd., Tokyo 101-8010 (JP)
(72) Inventor: Ohashi, Shigeo c/o Hitachi, Ltd., Intellectual, 1-chome, Chiyoda-ku Tokyo 100-8220 (JP); Naganawa, Takashi c/o Hitachi, Ltd., Intellectual, 1-chome, Chiyoda-ku Tokyo 100-8220 (JP); Minamitani, Rintaro c/o Hitachi, Ltd.,Intellectual, 1-chome, Chiyoda-ku Tokyo 100-8220 (JP); Nishihara, Atsuo c/o Hitachi, Ltd., Intellectual, 1-chome, Chiyoda-ku Tokyo 100-8220 (JP)
(74) Representative: Beetz & Partner

(57) **Abstract**

In an electronic apparatus having a liquid cooling system, and enabling optimal cooling characteristic for capacity with the aid of a radiator, which can be disposed or located fitting in a narrow space within a housing thereof, wherein a CPU (200) in need of cooling is installed within the housing (100), and the liquid cooling system for cooling the CPU comprises a cooling jacket (50) and a radiator therein, wherein the radiator has a pair of headers (62) and (62), being constructed with disposing a large number of metal thin tubes (61,61...) there between, aligned in parallel to each other, and an outer configuration thereof can be changed easily and freely, and therefore it can be positioned even in the narrow space. Further, a cooling fan (64) or (66) for cooling the radiator (60) may be disposed therein, and in that case it is also possible to maintain a position for setting up a motor (65) or (67) for rotationally driving the fan, included therein.

## Description

### BACKGROUND OF THE INVENTION

The present invention relates to an electronic apparatus, such as, a personal computer, being so-called a desktop-type or a notebook-type, or a server, etc., and in particular, it relates to an electronic apparatus having a liquid cooling system therein, thereby being able to cool down a heat-generation element mounted within an inside thereof, such as, a semiconductor integrated circuit (IC), effectively with an aid of a liquid refrigerant or coolant, and further the structure of a radiator suitable thereto and a manufacturing method thereof.

In order to maintain a normal operation thereof, cooling is necessary for the heat-generation element, such as, the semiconductor IC element, being mounted within an electronic apparatus, including a personal computer, of so-called the desktop-type or the notebook-type, as well as, a server, etc., and in particular, the heat-generation element, such as, a CPU (Central Processing Unit), as a representative one thereof, for example. For this reason, conventionally, such the cooling is achieved generally by using a heat transfer element, being so-called a heat sink that is formed with fins thereon, as well as a fan, being provided for sending a cooling air thereto. However, small-sizing and high integration of such the semiconductor IC element, such as the heat-generation element, in recent years, brings about localization of the heat generating at a portion thereof within the heat-generation element, and also for this reason, attention comes to be paid onto a cooling system of a liquid type of using the liquid coolant therein, such as a water, for example, being high in the cooling efficiency thereof, in the place of the conventional cooling system of an air-cooling type.

Namely, with the liquid cooling system of being high in the cooling efficiency thereof, which is used in the personal computer, of so-called the desktop-type or the notebook-type, and also the server, etc., as is known from the following patent documents, for example, in general, an element being so-called by a heat-receiving (or cooler) jacket is mounted on the surface of the heat-generating element, i.e., the CPU, directly, while conducting the liquid coolant within a flow passage formed within the heat-receiving jacket, so as to transmit or convey the heat generated from the CPU to the coolant flowing within the jacket mentioned above, thereby cooling down the heat-generating element with high efficiency. Further, in such the cooling system of the liquid-cooling type, normally, a heat cycle is made up with the cooler jacket, as the heat-receiving portion thereof, and in more details thereof, it comprises a circulation pump for circulating the liquid coolant mentioned above within the cycle, so-called a radiator, being a heat-radiation portion for irradiating heat of the liquid coolant mentioned above into an outside, and further a coolant tank provided in a part of the cycle depending on the necessity thereof. And, those are connected through a tube made of a metal and/or an elastic material, such as rubber or the like, for example.
Patent Document 1: Japanese Patent Laying-Open No. Hei 6-266474 (1995); and
Patent Document 2: Japanese Patent Laying-Open No. Hei 5-264139 (1994).

By the way, with the cooling system in relation to the conventional arts mentioned above, as a heat radiating portion for radiation the heat of the liquid coolant receiving heat within the cooler jacket mentioned above into an outside of the apparatus, such as, the radiator, normally a device is used in many cases, which is made up by winding around a metal thin tube, being made of copper, for example, in a zigzag manner, and further attached with fins for use of heat radiation on this metal thin tube, so as to improve the heat-radiation characteristic or capacity thereof. Or, alternately, it is made up with the metal thin tube, on which the fins are attached in advance, being wound around in the zigzag manner.

However, with such the radiator of the conventional arts, in particular, being made up with attaching the heat radiation fins on the metal thin tube zigzagged, which is actually used widely in the personal computer, being so-called the desktop type, and/or the server, etc., it has a drawback that the production process thereof is complex and takes much man-hour, therefore is relatively expensive on costs thereof. Also, with such the radiator of the conventional arts, due to the structure thereof, normally it must be manufactured into a predetermined shape, mainly in a plate-like or a cubic-like outer configuration of the radiator, as a whole.

On the other hand, for such computer of the desktop-type personal and the server, etc., in particular, due to the demands upon small-sizing and space-saving made in recent years, and also the recent currency of lowering the selling price thereof, it is not always possible to keep an enough space therein, to dispose the radiator having such the predetermined shape or configuration therein, so as obtain the optimal cooling characteristics or performances therefrom. However, actually, there are rather cases very often, wherein the radiator must be stuff into a narrow space remaining within an inside of the housing, forcefully. In such the cases, it is impossible to obtain the cooling function, fully from the radiator, and therefore there is a problem that the distinctive character of the liquid cooling system cannot be achieved in the actual use thereof. In addition thereto, with such the conventional arts mentioned above, also due to the complex manufacturing process thereof, it is difficult to manufacture the radiator having an outer shape or configuration being freely variable fitting to the narrow space remaining within the housing.

### SUMMARY OF THE INVENTION

Then, an object according to the present invention, being accomplished by taking the drawbacks of the conventional arts mentioned above into the consideration thereof, it is to provide a radiator having the structure, so that it can be easily disposed even within the narrow space remaining within the housing, fitting thereof, and can be altered in the outer configuration thereof, as well as, can be manufactured cheaply, thereby to provide an electronic apparatus having the liquid cooling system therein, which can obtain the optimal cooling characteristics with using such the radiator, and further a manufacturing method of such the radiator.

According to the present invention, for accomplishing such the object mentioned above, firstly, there is provided an electronic apparatus, installing a semiconductor element within a housing thereof, which necessitates cooling for maintaining normal operation thereof, in a part of the housing, and having a cooling system, within said housing or in a part thereof, said cooling system, comprising: a cooling jacket, being thematically connected with said semiconductor element, for transmitting heat generated therein to a liquid coolant flowing within an inside thereof; a radiator for radiating the heat transmitted into the liquid coolant within said cooling jacket into an outside of the apparatus; and a circulation pump for circulating said liquid coolant in a loop, including said cooling jacket and said radiator therein, wherein: said radiator is built up, by disposing a plural number of metal thin tubes aligning in parallel to each other. Further, according to the present invention, it is preferable, in the electronic apparatus, as described in above, that said metal thin tube has a circular cross-section thereof, and said radiator comprises a ventilating means in a part thereof.

Also, according to the present invention, for accomplishing such the object mentioned above, there is provided a radiator for use in the electronic apparatus described in the claim 1, comprising: at least, a pair of header portions disposed opposing to each other, wherein each of said pair of the header portions comprises: a plate-like member being made from a member, which is plate-like and is processed into a predetermined shape, with forming a plural number of penetrating holes therein, into which said plural number of the metal thin tubes are inserted; and a cover portion being formed to have an outer configuration corresponding to that of said plate-like member, and having a recess portion on an interior side thereof, wherein: said plural number of the metal thin tubes are fixed into said penetrating holes formed at positions corresponding thereto on said plate-like member building up said pair of the header portions, each being inserted therein at a tip thereof, thereby disposing said plural number of the metal thin tubes in parallel with each other. Further, according to the present invention, it is preferable, in the radiator as described in the above, that said plate-like member and said cover portion are formed to have outer configurations, corresponding to each other, or each of said plural number of the metal tin tubes fixed to said penetrating holes, being inserted therein at the tips thereof, has flange portions in vicinity of both end portions thereof.

In addition thereto, according to the present invention, for accomplishing such the object mentioned above, there is also provided a method for manufacturing the radiator, described in the claim 3, comprising the following steps of: preparing said plate-like members and said cover portions for building up said pair of the header portions, and further said plural pieces of the metal thin tubes; disposing and fixing said plural number of the metal thin tubes on said plate-like members for building up said pair of the header portions, at positions corresponding thereto, respectively; and disposing and fixing said cover portions on said plate-like members after disposing and fixing said plural number of the metal thin tubes at the corresponding positions. Further, according to the present invention, in the method for manufacturing the radiator, described in the above, it is preferable that said plural number of the penetrating holes are formed on a surface of said plate-like member through punching process, or that said plural number of the metal thin tubes are fixed on said plate-like members for building up said pair of the headers, at the corresponding positions, through brazing.

### BRIEF DESCRIPTION OF THE VARIOUS VIEWS OF THE DRAWING

Those and other features, objects and advantages of the present invention will become more apparent from the following description when taken in conjunction with the accompanying drawings wherein:
Fig. 1 is an exploded perspective view of a radiator portion, which builds up the distinctive feature according to the present invention, for showing the detailed structure thereof;
Fig. 2 is a perspective view for showing an example of the arrangement of each part partially exploded thereof, within a personal computer, of so-called the desktop type, for example;
Fig. 3 is a perspective view of an electronic circuit portion within the electronic apparatus mentioned above, in particular, for showing the entirety of the cooling system thereof;
Figs. 4(a) to 4(d) are views for explaining an example of the details of processes for manufacturing the radiator mentioned above;
Fig. 5 is a cross-section view for showing a portion of a metal thin pile enlargedly, which has flange portions on both end thereof, for showing a variation of the radiator mentioned above in the manufacturing method thereof;
Fig. 6 is a view for showing an example of arrangement of the radiator mentioned above, with using a space within the housing thereof, in the actual apparatus;
Figs. 7(a) and 7(b) are views for showing other example of arrangement of the radiator mentioned above, with using a space within the housing thereof, in the actual apparatus; and

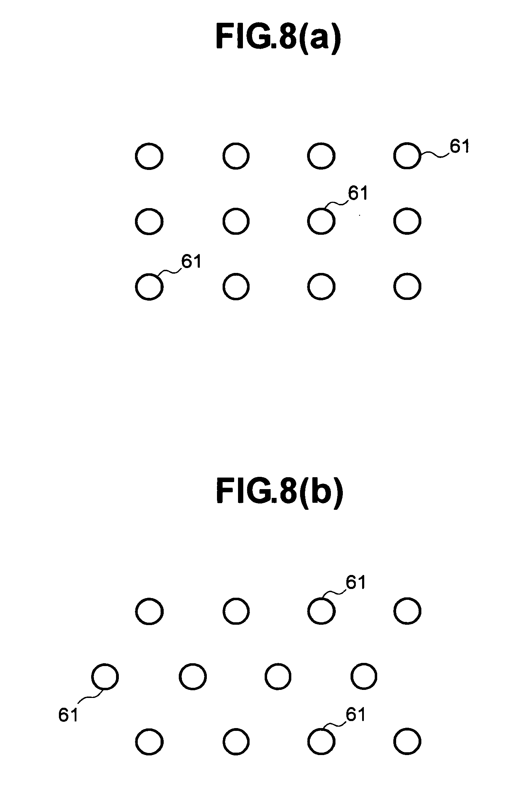

Figs. 8(a) and 8(b) are views for showing examples of dispositions of a large number of metal thin tubes, in the radiator mentioned above.

### DETAILED DESCRIPTION OF THE INVENTION

Hereinafter, explanation will be given on the embodiments according to the present invention, in details thereof, by referring to the drawings attached herewith.

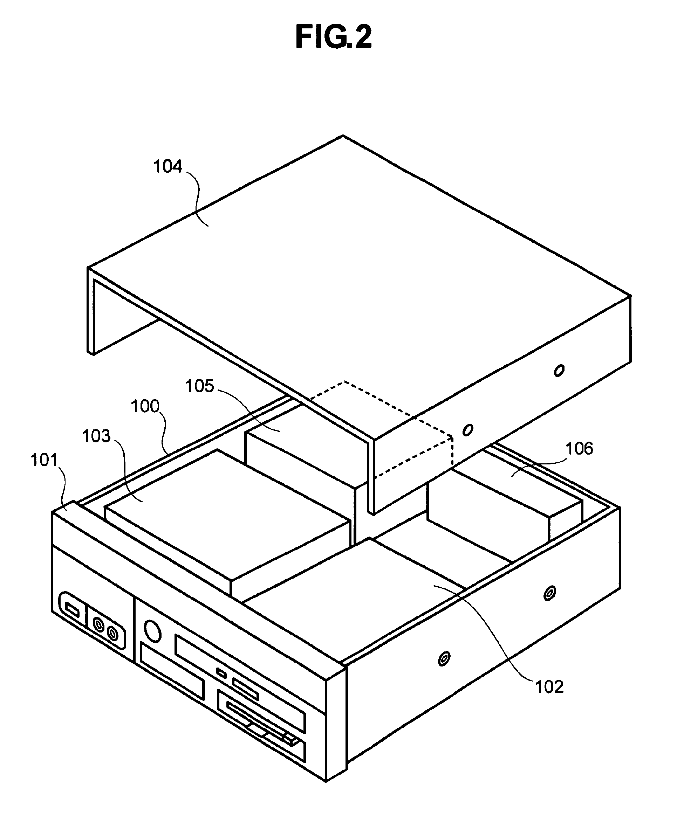

First, Fig. 2 attached herewith shows an example of the entire structure of an electronic apparatus having a liquid cooling system therein, according to one embodiment of the present invention. However, in this embodiment, there is shown a case, where the present invention is applied into a main portion of a personal computer, such as, of the desktop type, for example.

As shown in the figure, the main part or portion of the desktop type personal computer comprises a housing 100, which is formed from a metal plate into a cubic shape thereof, for example, and on a front panel portion 101 thereof are provided various kinds of switches, including an electric power switch therein, and indicator lamps, etc. Also, within an inside thereof is disposed a driver device 102, for driving various kinds of external information recording medium, such as, a floppy disk, a CD, and a DVD, etc., so that it positions an opening thereof on the front panel portion 101. Also, a reference numeral 103 in the figure depicts a memory portion provided within the housing 100 mentioned above, comprising a hard disk device therein, for example. And also, a reference numeral 104 in the figure depicts a cover to be put on the housing 100 mentioned above.

While on a rear side of the housing 100 is disposed an electronic circuit portion 105, having a liquid cooling system according to the present invention, and a reference numeral 106 in the figure depicts an electric power source portion for supplying from a commercial electric power source, a desired electric power to each of the portions, including, the driver device 102, the memory portion 103, and the electronic circuit portion 105 mentioned above.

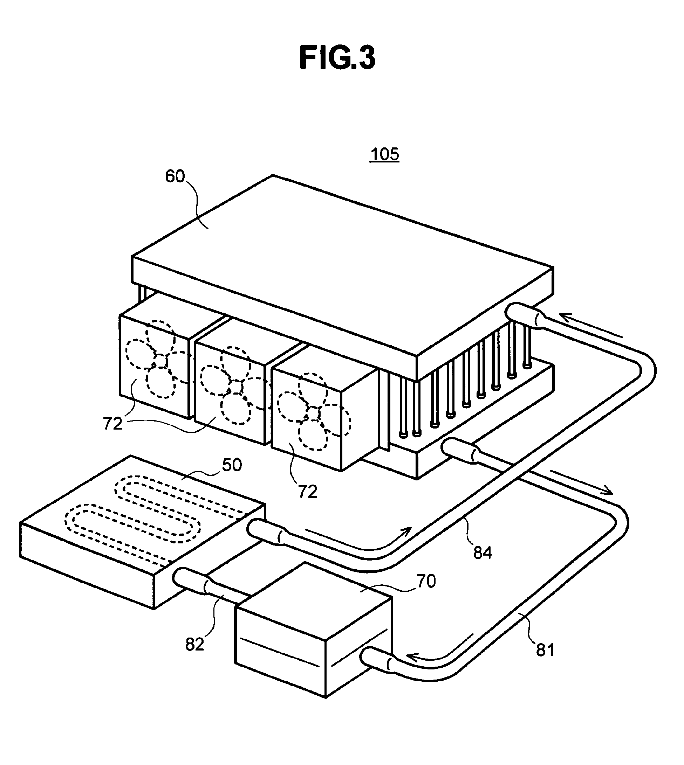

Next, in Fig. 3 attached herewith is shown the electronic circuit portion 105 of the electronic apparatus, the brief structure of which was explained in the above; i.e., within the desktop type personal computer, in particular, mainly around a heat receiving jacket 50 for mounting thereon a heat-generation element, such as, a CPU, as a main or principle structure thereof. However, in this embodiment, a chip 200 of the CPU, being the heat-generation element, is mounted on the lower side surface of the heat-receiving jacket 50 mentioned above, being in contact with, directly, therefore it is not illustrated on the figure, herein.

And, as is apparent from the figure, this electronic circuit portion 105 comprises the above-mentioned heat-receiving (or cooling) jacket 50 for mounting the CPU thereon, a radiator portion 60 for radiating heat generated from the CPU into an outside of the apparatus, a pump 70 for building up a cooling system, and further flow passages are formed by connecting tubes (conduits) 81, 82..., being made of a metal, or an elastic material, such as a rubber or the like, being covered with a metal film, etc. on the outer surface thereof, so as to prevent the liquid coolant inside from leaking outside, for conducting or communicating a liquid coolant (for example, a water, or a mixture of water with a so-called anti-freezing solution, such as, propylene glycol, at a predetermined ratio thereof) to each of those portions building up the heat cycle. Also, in a part of the radiator portion 60 mentioned above, there are attached with plate-like shaped fans 72, 72... (in a plural number, such as, three (3) pieces, in the present example), directing into an outside of the apparatus, so as to blow an air onto a large number of metal thin pipes 61, 61... as the constituent element thereof, which will be mentioned in more detail later, thereby radiating the heat transmitted from the heat receiving jacket 50 mentioned above, compulsively into an outside. Further, this heat-receiving (or cooling) jacket 50 is a plate-like member, being made of a metal having high heat conductivity, such as cupper or the like, and being formed with a cooling passage within an inside thereof, to conduct or communicate the liquid coolant into the passage thereof, thereby removing (moving) the heat generated from the CPU into the outside.

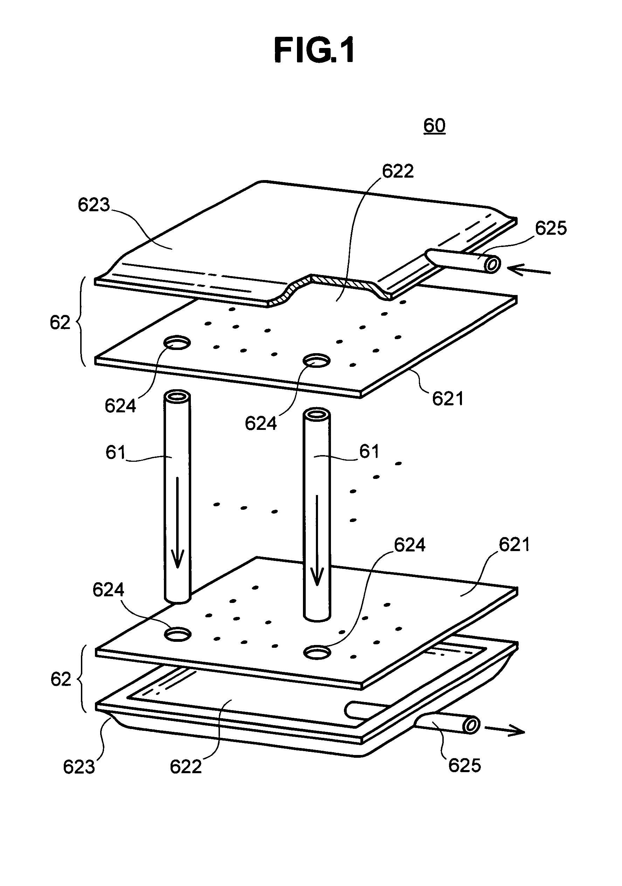

Following to the above, Fig. 1 attached herewith shows the details of the structure of the radiator portion 60 mentioned above, in the form of an exploded view thereof. Namely, as is apparent from this figure, the radiator portion 60 is built up with a pair of headers 62 and 62, being disposed vertically or horizontally, for example, and also a large number of thin tubes 61, 61..., each being connected therebetween in parallel with one another. However, in this figure, the thin tubes 61 are shown therein while being enlarged in the diameter thereof, for the purpose of explanation. In more details, the radiator according to the present example, it is built up, by connecting about 400 pieces of the thin tubes 61, 61... (having an inner diameter from 0.5mm to 1mm, for example), each being made of metals having superior heat conductivity, such as, copper, aluminum, etc., with each of the headers 62 having the sized of 100mm x 40mm, for example, in parallel with, respectively.

Explaining in more details thereof, as is apparent form the figure, each of the headers 62 mentioned above comprises one (1) piece of plate-like member 621, having a predetermined shape (in this example, a square shape), and also a cover member 623, which has an outer configuration corresponding to that of the plate-like member 621 (thus, being square in this example) and is formed with a recess or concaved portion 622 on an inner side thereof. On the each plate-like member 621, there are opened penetration holes 624, into which tip portion of the thin tubes 61 are inserted, in the number same to that of the tubes. However, each of those plate-likemembers 621 and the cover members 623 can be manufactured, easily from a metal plate having superior heat conductivity, such as, copper and/or aluminum, etc., being cut out into the predetermined shape through conducting the punching or drawing process thereon. Also, a reference numeral 625 in the figure depicts tube-like members, each being attached onto the each cover member 623 mentioned above, thereby forming an inlet opening and an outlet opening for the liquid coolant, respectively. The each header 62 carries out the function as a reservoir tank for the liquid coolant, therefore the internal volume thereof is determined by an amount of liquid to be held within the cooling system (i.e., an amount of liquid being sufficient to compensate the amount of the liquid reduced accompanying with a long-time operation). Also, the outlet opening of the radiator is located in a lower side thereof, thereby to be connected to the suction side of the pump, and then an air mixing within the liquid coolant is held within the upper-side header (i.e., the inlet-opening side of the radiator); therefore, it is possible to prevent the air from being sucked into the pump.

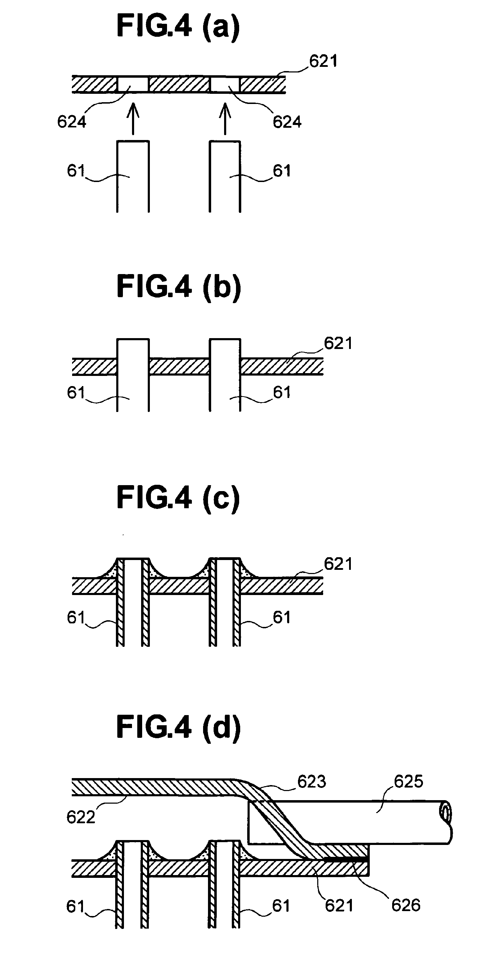

Next, Figs. 4(a) to 4(d) attached herewith show an example of the processes for inserting/fixing the metal thin tubes 61 into the penetrating holes 624 formed in the plate-like member 621, which builds up the header 62 mentioned above. First, the plate-like member 621 being made up in such the manner as was mentioned above and the metal thin tubes 61 are prepared (see Fig. 4(a)). Next, the metal thin tubes 61 are inserted into the penetrating holes 621 formed on the plate-like member 621 prepared, in such the extent that each protrudes the tip thereof a little bit (see Fig. 4(b)). Thereafter, the protruded portions of the metal thin tubes 61 and the plate-like member 621 are bonded and fixed together, therebetween through the brazing, or the like (see Fig. 4(c)). Finally, the cover member 623 mentioned above is mounted thereon from the above, and then those plate-like member 621 and the cover member 623 are bonded together with, around the outer peripheral portion thereof, through the electric welding, etc. (i.e., an outer-peripheral welding portion 626), thereby completing the radiator (see Fig. 4(d)). Or alternately, it is also possible to apply a method of bonding them together, collectively, within a furnace, etc., while putting a brazing material on the connection portions in advance.

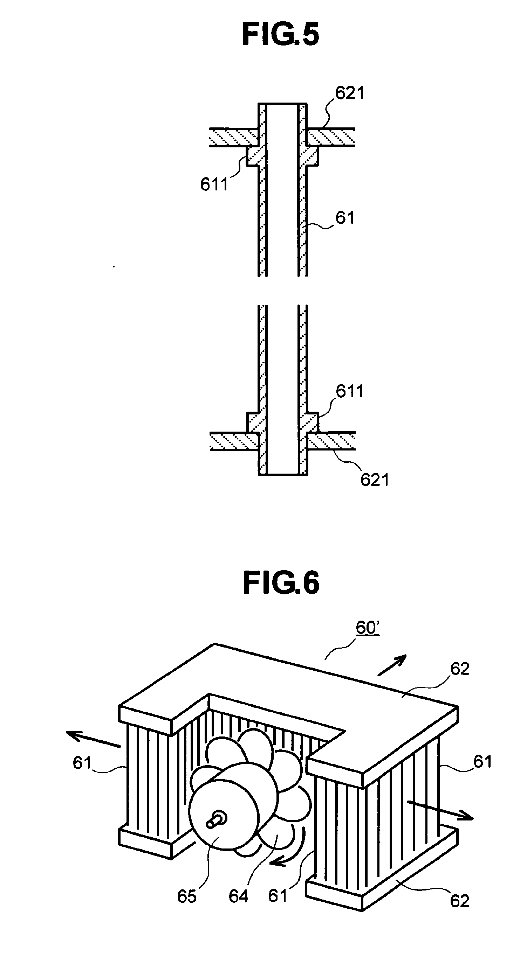

Also, during the manufacturing processes of the header 62 explained in the above, in particular, in a case where the metal thin tubes 61 are inserted into the penetrating holes 624, which are formed in the plate-like member 621, it is possible to make a flange portion 611 in advance, in particular, in the vicinity of the tip portion of the metal thin tube 61 to be inserted into, as shown in Fig. 5 attached herewith, for example (i.e., in the present example, at an upper or lower end portion). In this manner, with provision of the flange portion 611 in advances, in the vicinity of the tip portion of the metal thin tube 61, as is shown in the figure, it can bring about an easiness in bonding and inserting of the metal thin tubes 61 into the penetrating holes formed on the plate-like member 621, since the flange portion 611 carries out a role or function of positioning or stopping the metal thin tube 61 when it is inserted into the penetrating hole 624.

Next, explanation will be made about various embodiments, altering the radiator 60 in the outer configuration thereof, which can be manufactured easily, through the processes mentioned above. However, as is apparent from the explanation given in the above, with such the structure of the radiator 60 according to the present invention mentioned above, it is apparent that the configuration thereof can be changed easily, depending upon the shape of a pair of the headers 62 and 62, which are provided or disposed vertically or horizontally. Further, though was mentioned in the above, such adjustability of changing the outer configuration thereof is advantageous, in particular, to the personal computer, of so-called the desktop type, and/or the server, etc., in a case where the space is narrow remaining in an inside within the housing of the apparatus.

As an example thereof, Fig. 6 attached herewith shows an example of the radiator 60' suitable to be disposed within the narrow space, being narrow in the width but extending in the horizontal direction. As is apparent from the figure, the configuration of the pair of headers 62 and 62 mentioned above are shaped up to be "U"-like in the configuration, respectively, and a large number of the metal thin tubes 61 are disposed in parallel with between them, thereby building up the radiator 60'. Namely, with such the configuration of the radiator 60', as is shown in the figure, a cooling fan 64 can be disposed within a recess portion 63 formed in a part thereof, and thereby enabling an effective utilization of the limited space at the maximum. Further, an arrow shown in this figure indicates an airflow generated through the rotation of the cooling fan 64 mentioned above.

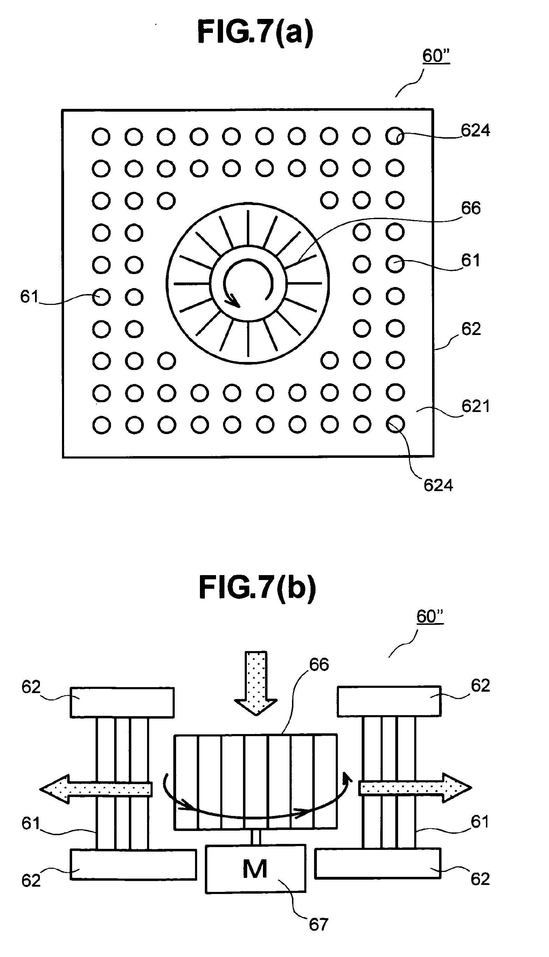

Further, Figs. 7(a) and 7(b) show an example of a radiator 60" suitable for to be disposed within a space remaining within the housing of the apparatus, being about cubic in the shape thereof and opening only in an upper portion thereof, as other example. Namely, as is apparent from the figure, each of the pair of headers 62 and 62, building up the radiator 62" mentioned above, is square in the outer configuration thereof, and is formed with a circular opening in the central portion thereof, respectively, in this embodiment. With the radiator 60" having such the configuration as was mentioned above, as is apparent from Fig. 7(b), in particular, it is possible to dispose a centrifugal fan 66 and an electric motor 67 for rotational driving thereof, into a space having a circular cross-section and opened in a central portion of the radiator 60". Thus, with such the structure, as is indicated by arrows in the figure, it is possible to suck an air from the space above the radiator 60", to be discharged or spouted out in the periphery thereof. In this manner, it is possible to make a setup, freely, including the disposition of the fan for conducting an air-blow and also the motor for rotational driving thereof, with utilizing the space remaining within the housing of an apparatus.

Although those radiators 60, 60' and 60" mentioned above are shown only in the disposition of being positioned, such that the pair of those headers 62 and 62 are located vertically, in the examples, however they should not be restricted thereto, but it is needless to mentioned about, in particular, that those can be disposed while directing the headers thereof horizontally, for example. And, in addition to the structure, being able to change the outer configuration thereof, freely, since the metal thin tubes 61 building up the heat-radiating portion thereof has no fin attached on the periphery thereof, in the structure, and further the outer periphery thereof is curved in the cylinder-like manner, therefore dusts hardly stick or adhere on the periphery thereof. Namely, adhesion of dusts on the heat-radiating portion is small in an amount thereof even with continuous use thereof for a long time period. For this reason, it is difficult to generate blocking in the passages for the cooling air, and therefore, reduction in the cooling capacity hardly occurs due to such the adhesion of such the dusts, etc. Furthermore, such the feature would be advantageous, in particular, to the server, etc., which should be continuously operated for a relatively long time period, from a viewpoint of maintenance thereof.

In addition thereto, the large number of metal thin tubes 61, building up such the radiators 60, 60' and 60", as was mentioned above, may be disposed or aligned on the surface of the header 62 (in more details, on the plate-like member 621 thereof), in a grid-like manner or a zigzag manner. Furthermore, other than those, those can be disposed at random in the position as far as they are in concert with each other between the positions where they are attached on the pair of headers 62 and 62. Accordingly, it is possible to achieve such a suitable pin arrangement, by taking the circulation of the cooling air by the fan into the consideration, and also the small or compact-sizing of the radiator, but without loosing the performance or capacity thereof.

As was fully explained in the above, according to the present invention mentioned above, it is possible to achieve the radiator having such the structure, that it can be also disposed in the narrow space remaining within the housing, easily, for example, in the personal computer of so-called the desktop type and the server, etc., and can be changed in the outer configuration thereof with easily, and manufactured cheaply, thereby to provide an electronic apparatus having the cooling system, in which the optimal cooling characteristic or capacity can be obtained with utilizing such the radiator, as well as the manufacturing method of such the radiator.

The present invention may be embodied in other specific forms without departing from the spirit or essential feature or characteristics thereof. The present embodiment(s) is/are therefore to be considered in all respects as illustrative and not restrictive, the scope of the invention being indicated by the appended claims rather than by the forgoing description and range of equivalency of the claims are therefore to be embraces therein.

## Claims

1. An electronic apparatus, installing a semiconductor element within a housing thereof, which necessitates cooling for maintaining normal operation thereof, in a part of the housing, and having a cooling system, within said housing (100) or in a part thereof, said cooling system, comprising:
a cooling jacket (50), being thematically connected with said semiconductor element, for transmitting heat generated therein to a liquid coolant flowing within an inside thereof;
a radiator (60) for radiating the heat transmitted into the liquid coolant within said cooling jacket (50) into an outside of the apparatus; and
a circulation pump (70) for circulating said liquid coolant in a loop, including said cooling jacket (50) and said radiator (60) therein, wherein:
said radiator (60) is built up, by disposing a plural number of metal thin tubes (61) aligning in parallel to each other.

2. Electronic apparatus, according to claim 1, **characterized in that** said metal thin tube (61) has a circular cross-section thereof, and said radiator (60) comprises a ventilating means in a part thereof.

3. A radiator for an electronic apparatus, comprising:
at least, a pair of header portions (62, 62) disposed opposing to each other, wherein each of said pair of the header portions (62, 62) comprises:
a plate-like member (621) being made from a member, which is plate-like and is processed into a predetermined shape, with forming a plural number of penetrating holes (624) therein, into which said plural number of the metal thin tubes (61) are inserted; and
a cover portion (623) being formed to have an outer configuration corresponding to that of said plate-like member (621), and having a recess portion on an interior side thereof, wherein:
said plural number of the metal thin tubes (61) are fixed into said penetrating holes (624) formed at positions corresponding thereto on said plate-like member (621) building up said pair of the header portions (62), each being inserted therein at a tip thereof, thereby disposing said plural number of the metal thin tubes (61) in parallel with each other.

4. Radiator according to claim 3, **characterized in that** said plate-like member (621) and said cover portion (623) are formed to have outer configurations, corresponding to each other.

5. Radiator according to claim 3 or 4, **characterized in that** each of said plural number of the metal thin tubes (61) fixed to said penetrating holes (624), being inserted therein at the tips thereof, has flange portions (611) in vicinity of both end portions thereof.

6. A method for manufacturing a radiator, comprising the following steps of:
preparing plate-like members (621) and cover portions (623) for building up a pair of the header portions (62), and further plural pieces of metal thin tubes (61);
disposing and fixing said plural number of the metal thin tubes (61) on said plate-like members (621) for building up said pair of the header portions (62), at positions corresponding thereto, respectively; and
disposing and fixing said cover portions (623) on said plate-like members (621) after disposing and fixing said plural number of metal thin tubes (61) at the corresponding positions.

7. Method for manufacturing a radiator according to claim 6, **characterized in that** said plural number of the penetrating holes (624) are formed on a surface of said plate-like member (621) through a punching process.

8. Method for manufacturing a radiator according to claim 6 or 7, **characterized in that** said plural number of the metal thin tubes (61) are fixed on said plate-like members (621) for building up said pair of the headers (62), at the corresponding positions, through brazing.
